# EUROPEAN PATENT APPLICATION

(11) **EP 1 531 501 A2**
(43) Date of publication of application: **18.05.2005**
(21) Application number: 04026735.3
(22) Date of filing: 10.11.2004
(51) Int. Cl.: H01L 51/10, H01L 51/40, H05B 33/00

(54) **Organic electroluminescent devices**

(30) Priority: 13.11.2003 JP 2003384202; 25.10.2004 JP 2004309943
(71) Applicant: International Manufacturing and Engineering Services Co., Ltd., Fujisawa-shi, Kanagawa-ken (JP)
(72) Inventor: Endoh, Jun, Fujisawa-shi, Kanagawa-ken (JP); Kido, Junji, Yonezawa-shi, Yamagata-ken (JP)
(74) Representative: Schaumburg, Thoenes, Thurn, Landskron

(57) **Abstract**

An organic electroluminescent device includes an anode electrode layer (2), a cathode electrode layer (3) opposed to the anode electrode layer (2), and a luminous layer (30) containing an organic compound disposed between the anode electrode layer (2) and the cathode electrode layer (3). An excitation state of the organic compound in the luminous layer (30) is created upon a hole injection from the anode electrode layer (2), and an electron injection from the cathode electrode layer (3), thereby causing light emission in the organic electroluminescent device. An electron-accepting material (20) is provided in at least one hole transportation layer (11, 12) capable of transporting holes injected from the anode electrode layer (2) disposed between the anode electrode layer (2) and the cathode electrode layer (3), and the electron-accepting material (20) is positioned at a side which is not adjacent to the anode electrode layer (2).

## Description

### BACKGROUND OF THE INVENTION

### 1. Field of the Invention

The present invention relates to an organic electroluminescent device (organic EL device) used as a planar light source or as a display device.

### 2. Description of the Related Art

A great deal of interest has been directed toward organic EL devices in which a luminous layer thereof is constructed from an organic compound, due to being able to ensure a large area display at a low driving voltage.

To significantly increase the efficiency of organic EL devices, Tang et al. of Eastman Kodak Company, as is reported in Appl. Phys. Lett., 51, 913 (1987), have successfully achieved an organic EL device which can exhibit a high luminance and sufficient efficiency during practical use, i.e., a luminance of 1,000 cd/m² and an external quantum efficiency of 1% at an applied voltage of not more than 10 volts, when the organic EL device produced has a structure in which organic compound layers having different carrier transporting properties are laminated to thereby introduce holes and electrons with a good balance from an anode electrode layer and a cathode electrode layer, respectively, and the thickness of the organic compound layers is controlled to be not more than 2,000Å (2,000 x 10⁻¹⁰m).

In the development of such highly efficient organic EL devices, it has been already recognized that the technology for introducing electrons from a cathode electrode layer and holes from an anode electrode layer into an organic layer of organic EL devices without generating an energy barrier is important.

In Tang et al., described above, to reduce an energy barrier which can cause a problem when electrons are introduced from a metal electrode to an organic compound which is generally considered to be an electrically insulating material, magnesium (Mg) having a low work function (3.6 eV; 1 eV = 1.60218 x 10⁻¹⁹ J) is used. The work function referred to herein is based on the data described in CRC Handbook of Chemistry and Physics, 64th Edition). However, since magnesium is liable to be oxidized, is unstable and also has poor adhesion to the surface of organic materials, Tang et al. have suggested to use magnesium alloyed with silver (Ag; work function of 4.6 eV), since silver is relatively stable, and thus has a high work function and a good adhesion to the surface of the organic material. Magnesium and silver are co-deposited to form an alloy. Reference should be made to Kodak patents concerning the organic EL devices, because the history until Tang et al. have developed use of the magnesium alloy is described therein in detail.

In regard to the Kodak patents, the initially issued Kodak patents such as US Patent Nos. 4,356,429 and 4,539,507 teach that the low work function metal useful in the formation of a cathode electrode layer of the organic EL devices includes Al, In, Ag, Sn, Pb, Mg, Mn, and the like. Namely, the low work function metal was not defined with reference to the work function values thereof in these patents. Recently issued Kodak patents such as US Patent Nos. 4,885,211, 4,720,432 and 5,059,862 teach that the required driving voltage can be lowered with reduction of the work function of the metal used in the cathode electrode layer. Moreover, it is also disclosed that the low work function metal is defined as a metal having a work function of less than 4.0 eV, and any metal having a work function of 4.0 eV or more may be used as a mixture with the low work function metal having a work function of less than 4.0 eV, which is rather chemically instable, to form an alloy, thereby giving chemical stability to the resulting alloyed cathode electrode layer.

The stabilizing metal is referred to as a higher work function second metal, and candidate examples thereof include Al, Ag, Sn and Pb, which are described as the low work function metal in the initial Kodak patents cited above. These inconsistencies in the disclosures between the initial and later patents show that the Kodak patents have been invented as a result of repeated trial and error at the initial stage of development. Furthermore, in the Kodak patents described above, it is disclosed that the alkaline metals having the lowest work function should be removed from the candidate examples of the cathode metal, even though they can exhibit excellent functions in principle, because they have an excessively high reactivity for achieving a stable driving of the organic EL devices.

On the other hand, a group of the researchers of Toppan Printing Co. (cf. 51st periodical meeting, The Japan Society of Applied Physics, Preprint 28a-PB-4, p.1040) and a group of the researchers of Pioneer Co. (cf. 54th periodical meeting, The Japan Society of Applied Physics, Preprint 29p-ZC-15, p.1127) have discovered that if lithium (Li; work function: 2.9 eV), which is an alkaline metal and has a lower work function than that of Mg, and was excluded from the claims of the Kodak patents, is used and is alloyed with aluminum (Al; work function: 4.2 eV) to form a stabilized electron injection cathode electrode layer, a lower driving voltage and a higher luminance in comparison with those of the organic EL device using the Mg alloy can be obtained in the organic EL devices. Furthermore, as is reported in IEEE Trans. Electron Devices, 40, 1342 (1993), the inventors of the present invention have found that a two-layered cathode electrode layer produced by depositing lithium (Li) alone at a very small thickness of about 10Å on an organic compound layer, followed by laminating silver (Ag) onto the deposited Li layer, is effective to accomplish a low driving voltage in organic EL devices.

In addition, recently the inventors of the present invention have successfully found, as is reported in Appl. Phys. Lett., 73 (1998) 2866; "SID97DIGEST, p.775" and Japanese Unexamined Patent Publication (Kokai) No.10-270171 and the US counterpart thereof, US Patent No. 6,013,384, that in organic EL devices, if an alkaline metal such as lithium, an alkaline earth metal such as strontium or a rare earth metal such as samarium is doped into an organic layer adjacent to the cathode electrode layer in place of doping the same into the metal of the cathode electrode layer, the driving voltage can be reduced. This is considered to be because an organic molecule in the organic layer adjacent to the electrode is changed to the corresponding radical anion as the function of metal doping, thus largely reducing the barrier level to the electron injection from the cathode electrode layer. In this case, even if a higher work function metal having a work function of 4.0 eV or more such as aluminum is used as the metal of the cathode electrode layer, it becomes possible to reduce the driving voltage in the organic EL device. In addition, it has been confirmed, as disclosed in Japanese Unexamined Patent Publication (Kokai) No. 2002-332567, that higher work function electrode materials such as ITO, which are conventionally used in the formation of the anode electrode layer and are considered to be the most unsuitable for the formation of the cathode electrode layer, can be used to provide a drivable light-emissive device.

Moreover, the inventors of the present invention have proposed organic EL devices in Japanese Unexamined Patent Publication (Kokai) Nos. 11-233262 and 2000-182774. These organic EL devices are characterized by an organic layer in a portion adjacent to the cathode electrode layer being formed from an organometallic complex compound containing at least one metal ion of an alkaline metal ion, an alkaline earth metal ion and a rare earth metal ion, or is formed from a mixed layer of the organometallic complex compound and an electron-transporting organic compound, and the cathode electrode layer is formed from an electrode material which includes a thermally reducible metal capable of reducing in a vacuum an alkaline metal ion, an alkaline earth metal ion and a rare earth metal ion (contained in the organometallic complex compound in the mixed layer) to the corresponding metal (cf. The 10^{th} International Workshop on Inorganic and Organic Electroluminescence, p.61; Jpn. J. Appl., phys., Vol. 38(1999) L1348, Part 2, No. 11B, 15 November, Reference 12; Jpn. J. Appl., Phys., Vol. 41(2002) pp.L800).

In the electron injection layer having the above structure, during vapor deposition of the thermally reducible metals such as aluminum and zirconium under a vacuum, the thermally reducible metals can be vaporized in atomized state, i.e., in highly reactive conditions, and be deposited onto the organometallic complex compound, thereby reducing metal ions in the complex compound to the corresponding metal state and liberating the reduced metals therein. Furthermore, the reduced and liberated metals can cause an in-situ doping and reduction of the electron-transporting organic compound existing near the reduced and liberated metals (the reduction caused herein means the reduction defined by Lewis and thus acceptance of electrons). Accordingly, as in the above-described direct metal doping process, the electron-transporting organic compound can be changed to the radical anions.

According to the above method, aluminum is selected not by its level of the work function as in the conventional methods, but by the thermally reducible ability under a vacuum, i.e., new idea which had not yet been recognized by a person skilled in the art. Furthermore, a similar phenomenon has been observed and reported with regard to inorganic compounds containing an ion of a low work function metal such as alkaline metal ion (cf. Appl. Phys. Lett., Vol. 70, p.152 (1997); and IEEE Trans. Electron Devices, Vol. 44, No. 8, p.1245 (1997)).

As can be appreciated from the above-described historical descriptions of the electron injection technologies, in the development of organic EL devices, there have been continuous attempts to improve the electron injection electrodes (i.e, cathode electrode) and improve the method of forming an electron injection layer contacting the cathode electrode layer. As a result, the emission efficiency of the organic EL devices have been drastically improved and also it became possible to drive the devices at a low voltage. Accordingly, at present, the electron injection has been recognized to be an important technology for improving organic EL device properties in the production thereof.

Moreover, for the injection of holes into the organic layer, an indium-tin-oxide (ITO) is widely used as a transparent oxide electrode material having a relatively higher work function in the formation of an anode electrode layer in organic EL devices. Since light has to be extracted plane-wise in organic EL devices, the suitability of a transparent electrode like ITO, which has been already widely used in the production of the liquid crystal display devices, can be considered to be a result of unexpected luck, because ITO is a material which is relatively appropriate for hole injection into the organic layer due to its higher work function.

Furthermore, Tang et al. of Eastman Kodak Company have improved compatibility of an organic layer with an anode electrode layer by inserting a layer of copper phthalocyanine (hereinafter, CuPc) having a thickness of not more than 200 A between the anode electrode layer and the hole-transporting organic compound, thereby enabling the stable operation of organic EL devices at a low voltage and at a more stable state (cf. Appl. Phys. Lett., Vol. 69, (15), p.2160(1996), or Kodak, US Patent No. 5,061,569).

Furthermore, a group of the researchers of Pioneer Co., Ltd. have obtained similar effects by using starburst type arylamine compounds (m-MTDATA) proposed by Shirota et al. of Osaka University (cf. Appl. Phys. Lett., Vol.65, No.7. August 15, p.807 (1994)). Both CuPc and starburst type arylamine compounds such as m-MTDATA are known to exhibit an effect of reducing the barrier against the hole injection from the anode electrode layer, and thus stability of the organic EL device during continuous driving is improved by improving interfacial contact with the electrode, since CuPc and starburst type arylamine compounds have an ionization potential (Ip) equivalent or smaller than that of ITO. Furthermore, the starburst type arylamine compounds are known to be useful in avoiding a dangerous tendency of short-circuiting between the electrodes, since they are characterized by having a high transparency in the form of a layer and a relatively large hole mobility, and thus they can avoid a remarkable increase of the driving voltage at a relatively large layer thickness of about 1,000Å (about 100 nm).

Moreover, Idemitsu Co., Ltd. has developed a blue color light emission device showing a luminance half-life durability of 4,500 hours from an initial luminance of 1,000 cd/m2 using as a hole injection layer adjacent to the anode electrode layer an arylamine compound having a high hole mobility and a high glass transition temperature (Trade name: IDE406, details of the molecular structure are unknown (cf. "Monthly Display", Techno Times Co., Ltd., September 2001, p.25).

In addition, a group of the researchers of Toyota Central R&D Labs., Inc. have proposed an organic EL device in which a metal oxide such as vanadium oxide (VOₓ), ruthenium oxide (RuOₓ) or molybdenum oxide (MoOₓ), which has a larger work function than ITO, is deposited at a thickness of 50 to 300Å by sputtering on an ITO layer to thereby reduce an energy barrier generated during hole injection from the ITO layer (anode electrode layer) to the organic layer (cf. Japanese Patent No. 2824411 and J. Phys. D: Appl. Phys., 29 (1996) p.2750). In this organic EL device, the driving voltage can be considerably reduced in comparison with sole use of ITO.

Similarly, in regard to hole injection from the anode electrode layer, the assignee of the present invention, as disclosed in Japanese Unexamined Patent Publication (Kokai) Nos. 10-49771 and 2001-244079, has succeeded in further improving the hole injection property of organic EL devices, if ferric chloride (FeCl₃) (which is an electron-accepting material, is particularly widely known as a Lewis acid compound and is a metal halide) and an organic hole-transporting compound are mixed in an appropriate ratio using a co-deposition method to form a hole injection layer (cf. Jpn. J. Appl. Phys., Vol. 41 (2002) L358). In this organic EL device, since a Lewis acid compound capable of acting as an oxidation agent for the organic compound is, in due course, doped into a layer of the organic compound adjacent to the anode electrode layer, the organic compound is retained as molecules in the oxidized form (i.e., radical cation state), and as a result, an energy barrier during hole injection from the anode electrode layer can be reduced, thereby ensuring to further reduce a driving voltage of organic EL devices in comparison to the prior art organic EL devices.

Moreover, if a suitable combination of the organic compound and the Lewis acid compound is selected in this chemical doping layer, an increase of the driving voltage can be avoided, even if a thickness of this layer is increased to an order of micrometers, in contrast to the prior art layer constituted from only an undoped organic compound, and thus a dependency of the driving voltage upon the layer thickness of the chemical doping layer can be removed in the organic EL device (cf. Preprint of 47th periodical meeting of Japanese Society of Polymer, Vol.47, No.9, p.1940 (1998)). In addition, as is disclosed in Japanese Unexamined Patent Publication (Kokai) No. 2001-244079 (Japanese Patent Application No. 2000-54176), the above-described Lewis acid-doping layer may be used to control an optical path length of the organic EL device to thereby enable the layer to act as an emission spectrum controlling layer which can be utilized to improve a color purity of the display image.

In addition, the assignee of the present invention has disclosed in the specification of Japanese Patent Application No. 2003-358402 and No. 2004-202266 that an excellent hole injection characteristic can be obtained by forming a mixed layer of a metal oxide such as vanadium pentoxide (V₂O₅) or dirhenium heptaoxide (Re₂O₇) or molybdenum trioxide (MoO₃) o r tungsten trioxide (WO₃) and an organic hole-transporting compound, arylamine compound, as a hole injection layer adjacent to the anode electrode layer. In this organic EL device, the hole injection layer is characterized by simultaneously satisfying the low voltage driving comparable to that of the above-described hole injection layer using the Lewis acid compound and the stable driving of the device, and this characteristic is based on the specific property of the insulating n-type semiconductor (i.e., having the resistivity of about 10⁵ Ω cm or more) such as V₂O₅ (vanadium pentoxide) and the like listed above that the semiconductor has an ability of forming a charge transfer complex upon the oxidation-reduction reaction with the arylamine compound.

In addition, since the hole injection layer having mixed therein V₂O₅ (vanadium pentoxide) and the like enables hole to be injected regardless of the value of the work function of the material forming the anode electrode layer, a hole injection can be achieved without causing an injection barrier, even if a metal such as aluminum which was unsuitable for hole injection in the prior art organic EL devices is used in the formation of an anode electrode layer. Furthermore, since V₂O₅ and the like is chemically stable, there is no need for concern about corrosion (unlike in the case where a series of typical Lewis acid compounds like ferric chloride and the like are used) of the electrode metal.

### SUMMARY OF THE INVENTION

With regard to the hole injection technologies describe above, the features and drawbacks of each of the technologies are summarized as follows.

First, the hole injection layer with the mixed Lewis acid compound, suggested by the assignee of the present invention, is characterized by a driving voltage of an organic EL device not increasing with substantial increase of the thickness of the hole injection layer because of the low resistivity of the hole injection layer, and thus the hole injection layer is considered to be effective. On the other hand, generally, typical Lewis acid compounds are chemically instable and therefore they have poor storage stability. Furthermore, as a result of study, the inventors of the present invention have found that the Lewis acid compounds may slightly deteriorate the current efficiency (or quantum efficiency) of the organic EL device, while being able to reduce the driving voltage.

The lamination of a metal oxide having a large work function on the anode electrode layer, suggested by Toyota Central R&D Labs., Inc., has a limited applicable layer thickness due to low light transmittance of the metal oxide. Moreover, substantially all of the exemplified metal oxide compounds can only be deposited by a sputtering method to form a layer.

The hole injection layer using an organic compound having a small ionization potential, typically CuPc suggested by Tang et al., and an starburst type arylamine compound, for example, m-MTDATA, suggested by Shirota et al., can improve the contacting property at the anode electrode layer interface. However, due to such an upper limit for the layer thickness applicable to the formation of the hole injection layer, it is difficult to freely change the design of an organic EL device. Furthermore, it is essential for CuPc and the starburst type arylamine compound to be used as a hole injection layer adjacent to the anode electrode layer as in other hole injection layers, and that another hole transporting layer consisting of the organic compound having the different structures is further inserted between the hole injection layer and the luminous layer.

Typical examples of the above-described organic compound include TPD and NPB ( α NPD) described in the above-mentioned articles by Tang et al. and Shirota et al., and these compounds can exhibit a role to confine 'excited state' in the luminous layer as a result of effective blocking of the electrons from the cathode electrode layer, in addition to having a hole transportation characteristic. Similarly, it is essential for improving a light emission efficiency that the hole transportation material such as "IDE312" (commercial name; product of Idemitsu Co., Ltd.; details of the molecular structure are unknown) is inserted between the hole injection material such as "IDE406" (commercial name; product of Idemitsu Co.) and the luminous layer.

However, though it is not clearly described in the above articles, in practice, a barrier for the hole transfer can be formed in an interface between the hole injection layer (CuPc layer, m-MTDATA layer or IDE406) and the hole transportation layer (TPD layer, NPB layer or IDE312), and the formation of the hole transfer barrier is described in, for example, D. Berner et al., "International Workshop on Inorganic and Organic Electroluminescence & 2002 International Conference on the Science and Technology of Emissive Display and Lighting", ABSTRACT, p.503.

The formation or presence of such a hole transfer barrier are observed with the resulting increase of the driving voltage and the turn-on voltage, and of course, the increase of these voltages can result in reduction in the light emission efficiency (lm/W). Regardless of these circumstances, the CuPc and starburst type arylamine compounds are widely used as an excellent hole-injecting compound at present, because they can exhibit an excellent hole injection characteristic from the anode electrode layer, and also can exhibit an excellent thermal stability and layer formation stability, thereby remarkably improving a driving stability of organic EL devices.

In addition, among the various hole injection layers discussed above, the hole injection layer in the form of a mixed layer consisting of the metal oxide, V₂O₅ (vanadium pentoxide) or the like and the organic hole-transporting compound, arylamine compound, developed by the assignee of the present invention is one of the most effective hole injection layers, because it ensures advantages such as low resistivity, reduction in the barrier of the hole injection from the anode electrode layer and the above-described chemical stability. However, the inventors have studied and found in the driving durability test of the organic EL devices that the initial deterioration curve is somewhat steep, and thus the half-decay life of luminance is rather shortened in comparison with organic EL devices of the present invention which will be described hereinafter in detail.

The present invention is devised in view of solving the above-described problems, in the prior art organic EL devices, and simultaneously accomplishes a low voltage driving and a stabilization of the durability in organic EL devices not by applying an electro-accepting material such as typical Lewis acid compounds and metal oxides, described above, in a layer adjacent to the anode electrode, i.e., but by applying the electron-accepting material in a layer not adjacent to the anode electrode.

Furthermore, the present invention maintains driving durability stability in an organic EL device by using a combination of two or more hole transportation layers for transferring holes injected from an anode electrode layer to a luminous layer (At present, typical examples of the combination include "CuPc and NPB", "m-MTDATA and TPD" and "IDE406 and IDE312", described above, and other combinations include a combination of the conductive polymer such as PEDOT and PANI and the arylamine compound), and at the same time, solves the problems caused by using the combination of the hole transportation layers, i.e., to diminish a formation of a hole transfer barrier in an interface of the hole transportation layers constituted from different organic molecules so that a device driving voltage including an turn on voltage is lowered as a result, thereby reducing a power consumption.

In particular, the present invention simultaneously reduces the driving voltage and stabilizes the device driving in the organic EL device by forming a hole transportation layer as a combination of two or more hole transportation layers as in the prior art organic EL devices, but applying an electron-accepting material near an interface separating the hole transportation layers and also forming a charge transfer complex upon the oxidation-reduction reaction between the electron-accepting material and either or both of the two hole-transporting materials contacting the electron-accepting material, thereby converting the hole-transporting materials to a radical cation state and thus diminishing the formation of the hole transfer barrier, which could not be solved in the prior art organic EL devices.

As is disclosed in Japanese Unexamined Patent Publication (Kokai) Nos. 10-49771 and 2001-244079 and Japanese Patent Application No. 2003-358402, the inventors of the present invention have achieved a low driving voltage and an increased efficiency in organic EL devices by mixing and applying an electron-donating compound such as arylamine compounds, which are widely used as an organic hole-transporting compound, and an electron-accepting compound capable of forming a charge transfer complex upon the oxidation-reduction reaction to a section of the hole injection layer adjacent to the anode electrode layer.

The present invention achieves stability in the driving voltage in addition to the above-mentioned features. However, the present invention does not rely upon application of an electron-accepting compound to a section of the hole injection layer adjacent to the anode electrode layer. The present invention achieves a low driving voltage in organic EL devices in which two or more hole transportation layers, which are used to attain a driving stability in the prior art EL devices are contained without modification, by applying an electron-accepting material to an interface separating said different hole transportation layers.

According to an aspect of the present invention, an organic electroluminescent device is provided, including an anode electrode layer, a cathode electrode layer opposed to the anode electrode layer, and a luminous layer containing an organic compound disposed between the anode electrode layer and the cathode electrode layer. An excited state of the organic compound in the luminous layer is created upon a hole injection from the anode electrode layer, and an electron injection from the cathode electrode layer, thereby causing light emission in the organic electroluminescent device. An electron-accepting material is provided in hole transportation layers (consisting of at least one layer) capable of transporting holes injected from the anode electrode layer disposed between the anode electrode layer and the cathode electrode layer, and the electron-accepting material is positioned at a site which is not adjacent to the anode electrode layer.

It is desirable for the hole transportation layer to include at least two hole transportation layers which independently include different materials, and wherein an electron-accepting material is included in an interface separating the hole transportation layers.

It is desirable for the electron-accepting material to be in the form of a layer sandwiched between the hole transportation layers.

It is desirable for the electron-accepting material to be mixed in at least one of the hole transportation layers adjacent to each other.

It is desirable for the hole transportation layer to include a hole-transporting material, and the electron-accepting material and the hole-transporting material to constitute a mixture layer formed upon co-deposition of the electron-accepting material and the hole-transporting material.

It is desirable for the electron-accepting material to include an inorganic material.

It is desirable for the electron-accepting material to include an organic material.

It is desirable for the inorganic material as the electron-accepting material to include a metal oxide.

It is desirable for the inorganic material as the electron-accepting material to include a metal halide.

It is desirable for the metal oxide as the electron-accepting material to include one of vanadium pentoxide (V₂O₅), dirhenium heptaoxide (Re₂O₇), molybdenum trioxide (MoO₃), and tungsten trioxide (WO₃).

It is desirable for the organic material as the electron-accepting material to include at least one fluorine atom as a substituent group.

It is desirable for the organic material as the electron-accepting material to be tetrafluoro-tetracyanoquinodimethane (F₄-TCNQ).

It is desirable for the organic material as the electron-accepting material to include a boron atom and a fluorine atom.

It is desirable for the organic material as the electron-accepting material to include at least one cyano group as a substituent group.

It is desirable for the organic material as the electron-accepting material to include a boron atom.

It is desirable for the organic material as the electron-accepting material to include tris-β-(pentafluoronaphthyl)borane (PNB).

It is desirable for the organic hole-transporting material contacting the organic electron-accepting material to include an arylamine compound represented by the following formula: 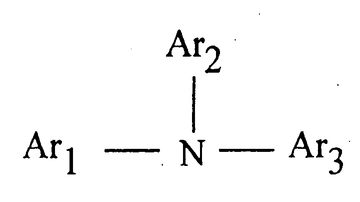 in which Ar₁, Ar₂ and Ar₃ each represents an aromatic hydrocarbon group which may have substituents independently.

It is desirable for the organic hole-transporting material contacting the organic electron-accepting material to include a pigment type organic compound.

It is desirable for the pigment type organic compound to include a porphyrin compound or a derivative thereof.

It is desirable for the pigment type organic compound to include a quinacridone compound or a derivative thereof.

It is desirable for the pigment type organic compound to include an indanthrene compound or a derivative thereof.

In another embodiment, an organic electroluminescent device is provided, including an anode electrode layer and a cathode electrode layer which are disposed opposite to each other, and at least two light emissive units each including at least one luminous layer. The light emissive units are partitioned with at least one charge generation layer, the charge generation layer is an electrical insulating layer having a resistivity of not less than 1.0 × 10² Ω cm, the light emissive unit includes at least one hole transportation layer, at least one of the light emissive units includes an electron-accepting material in the hole transportation layer, and the electron-accepting material is positioned at a site which is not adjacent to the anode electrode layer and the charge generation layer.

It is desirable for the hole transportation layer to include at least two hole transportation layers which independently include different materials, and an electron-accepting material is included in an interface separating the adjacent hole transportation layers.

It is desirable for the electron-accepting material to be in the form of a layer sandwiched between the hole transportation layers.

It is desirable for the electron-accepting material to be mixed in at least one of the hole transportation layers adjacent to each other.

It is desirable for the hole transportation layer to include a hole-transporting material. The electron-accepting material and the hole-transporting material include a mixture formed upon co-deposition of the electron-accepting material and the hole-transporting material.

Furthermore, in practice, it is desirable for the organic hole-transporting material contacting the organic electron-accepting material to include a pigment type organic compound, for example, a porphyrin compound or a derivative thereof such as copper phthalocyanine (CuPc), described above (cf. Appl. Phys. Lett., Vol. 69, (15), p.2160(1996), or Kodak, US Patent No. 5,061,569), a quinacridone compound or a derivative thereof described in 39th periodical meeting, Society of Applied Physics, Preprint 28p-Q-9, p.1036 (1992), and an indanthrene compound or a derivative thereof described in Japanese Unexamined Patent Publication (Kokai) No. 2000-58267.

### BRIEF DESCRIPTION OF THE DRAWINGS

Figure 1A is a schematic view showing the lamination structure of a prior art organic EL device according to Reference Example;
Figure 1B is a schematic view showing a lamination structure of an organic EL device (A) according to the present invention;
Figure 1C is a schematic view showing a lamination structure of an organic EL device (B), (C) or (F) according to the present invention;
Figure 1D is a schematic view showing a lamination structure of an organic EL device (D) according to the present invention;
Figure 1E is a schematic view showing a lamination structure of an organic EL device (E) according to the present invention;
Figure 2 is a graph of the absorption spectrum obtained with use of 2-TNATA, α NPD, spiro-TAD, spiro-NPB or V₂O₅ (vanadium pentoxide) as a single layer, and with use of each of the arylamine compounds and vanadium pentoxide as a mixed layer;
Figure 3 is a graph of the absorption spectrum obtained with a mixed layer of αNPD and Re₂O₇ (dirhenium heptaoxide);
Figure 4 is a graph of the absorption spectrum obtained with use of 2-TNATA or tetrafluoro-tetracyanoquinodimethane as a single layer, and with use of 2-TNATA and tetrafluoro-tetracyanoquinodimethane as a mixed layer;
Figure 5 is a schematic view of an organic EL device in which a hole-transporting material and an electron-accepting material are laminated and are in contact with each other;
Figure 6 is a schematic view of the organic EL device in which a mixed layer of a hole-transporting material and an electron-accepting material is inserted between the layer-wise laminated hole-transporting material and electron-accepting material;
Figure 7 is a schematic view showing a lamination structure of an organic EL device according to Reference Example 1;
Figure 8 is a schematic view showing a lamination structure of an organic EL device according to Example 1;
Figure 9 is a schematic view showing a lamination structure of an organic EL device according to Reference Example 2;
Figure 10 is a schematic view showing a lamination structure of an organic EL device according to Example 2;
Figure 11 is a graph showing a characteristic curve of a current density (mA/cm²) to a driving voltage (V) with regard to the organic EL devices according to Reference Example 1 and Example 1;
Figure 12 is a graph showing a characteristic curve of a luminance (cd/m²) to a driving voltage (V) with regard to the organic EL devices according to Reference Example 1 and Example 1;
Figure 13 is a graph showing a characteristic curve of a power efficiency (lm/W) to a luminance (cd/m²) with regard to the organic EL devices according to Reference Example 1 and Example 1;
Figure 14 is a graph showing a characteristic curve of a current density (mA/cm²) to a driving voltage (V) with regard to the organic EL devices according to Reference Example 2 and Example 2;
Figure 15 is a graph showing a characteristic curve of a luminance (cd/m²) to a driving voltage (V) with regard to the organic EL devices according to Reference Example 2 and Example 2;
Figure 16 is a graph showing a characteristic curve of a power efficiency (lm/W) to a luminance (cd/m²) with regard to the organic EL devices according to Reference Example 2 and Example 2;
Figure 17 is a schematic view showing a lamination structure of an organic EL device according to Example 3;
Figure 18 is a graph showing a characteristic curve of a current density (mA/cm²) to a driving voltage (V) with regard to the organic EL devices according to Reference Example 2 and Example 3;
Figure 19 is a graph showing a characteristic curve of a luminance (cd/m²) to a driving voltage (V) with regard to the organic EL devices according to Reference Example 2 and Example 3;
Figure 20 is a graph showing a characteristic curve of a power efficiency (lm/W) to a luminance (cd/m²) with regard to the organic EL devices according to Reference Example 2 and Example 3;
Figure 21 is a plan view showing a resistivity evaluation device having a sandwiched structure;
Figure 22 is a cross-sectional view of the resistivity evaluation device taken along line XXII - XXII of Figure 21;
Figure 23 is a plan view showing a resistivity evaluation device having a co-planar structure;
Figure 24 is a cross-sectional view of the resistivity evaluation device taken along line XXIV - XXIV of Figure 23;
Figure 25 is a graph showing a characteristic curve of a current density (A/cm²) to an electric field (V/cm) with regard to the organic EL device according to Test Example;
Figure 26 is a graph showing the relationship between Mole Fraction of V₂O₅ or α-NPD in the co-deposition layer and a resistivity (Ωcm) thereof;
Figure 27 is a graph showing a characteristic curve of a current density (mA/cm²) to a driving voltage (V) with regard to the organic EL devices according to Reference Example 2 and Example 4;
Figure 28 is a graph showing a characteristic curve of a luminance (cd/m²) to a driving voltage (V) with regard to the organic EL devices according to Reference Example 2 and Example 4;
Figure 29 is a graph showing a characteristic curve of a power efficiency (lm/W) to a luminance (cd/m²) with regard to the organic EL devices according to Reference Example 2 and Example 4; and
Figure 30 is a schematic view showing the lamination structure of the organic EL device according to Example 4.

### DESCRIPTION OF THE PREFERRED EMBODIMENTS

The embodiments of the organic EL device according to the present invention is characterized by having a combination of a hole transportation layer consisting of two or more layers adjacent to an anode electrode layer and hole transporting molecules constituting the hole transportation layer, and an electron-accepting material layer and electron-accepting materials constituting the electron-accepting material layer, and specific examples of such an organic EL device according to the present invention include the following organic EL device structures (A) to (F).

### Structure (A):

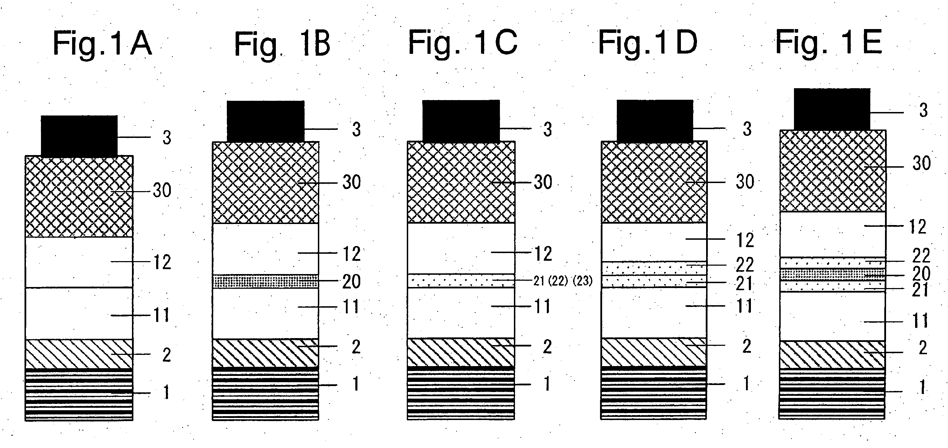

Substrate 1/Anode Electrode Layer 2/First Hole Transportation Layer 11/Electron-accepting Material Layer 20/Second Hole transportation Layer 12/Organic Structure 30 Including Luminous layer/Cathode Electrode Layer 3 [Figure 1B]

### Structure (B):

Substrate 1/Anode Electrode Layer 2/First Hole Transportation Layer 11/Mixed Layer 21 of First Hole-transporting Molecule and Electron-accepting Material/Second Hole transportation Layer 12/Organic Structure 30 Including Luminous layer/Cathode Electrode Layer 3 [Figure 1C]

### Structure(C):

Substrate 1/Anode Electrode Layer 2/First Hole Transportation Layer 11/Mixed Layer 22 of Second Hole-transporting Molecule and Electron-accepting Material/Second Hole transportation Layer 12/Organic Structure 30 Including Luminous layer/Cathode Electrode Layer 3 [Figure 1C]

### Structure (D):

Substrate 1/Anode Electrode Layer 2/First Hole Transportation Layer 11/ Mixed Layer 21 of First Hole-transporting Molecule and Electron-accepting Material/Mixed Layer 22 of Second Hole-transporting Molecule and Electron-accepting Material/Second Hole transportation Layer 12/Organic Structure 30 Including Luminous layer/Cathode Electrode Layer 3 [Figure 1D]

### Structure (E):

Substrate 1/Anode Electrode Layer 2/First Hole Transportation Layer 11/ Mixed Layer 21 of First Hole-transporting Molecule and Electron-accepting Material/Electron-accepting Material Layer 20/Mixed Layer 22 of Second Hole-transporting Molecule and Electron-accepting Material/Second Hole transportation Layer 12/Organic Structure 30 Including Luminous layer/Cathode Electrode Layer 3 [Figure 1E]

### Structure (F):

Substrate 1/Anode Electrode Layer 2/First Hole Transportation Layer 11/ Mixed Layer 23 of First Hole-transporting Molecule, Second Hole-transporting Molecule and Electron-accepting Material/Second Hole transportation Layer 12/Organic Structure 30 Including Luminous layer/Cathode Electrode Layer 3 [Figure 1C]

In the organic EL device structures described above, the hole-transporting molecules used in the formation of the first hole transportation layer 11 and those used in the formation of the second hole transportation layer 12 may be the same or different. The present invention is not restricted to the described device structures, as long as the electron-accepting molecules are contained in a position not contacting the anode electrode, but are contacting the hole-transporting molecules so that the hole-transporting molecules are converted to radical cations.

The organic EL device structures (A) to (F), described above according to the present invention are schematically illustrated in Figures 1(b) to 1(e), along with the organic EL device structure of the prior art organic EL device. Note that a typical example of the prior art organic EL device is illustrated in Figure 1A, and has the organic EL device structure:
Substrate 1 / Anode Electrode Layer 2 / First Hole Transportation Layer 11 / Second Hole transportation Layer 12 / Organic Structure 30 Including Luminous layer / Cathode Electrode Layer 3.

In the above examples of the organic EL device structures of the present invention, two different compounds are used in the formation of a section of the hole transportation layers. However, one or more different compounds may be further used to form a section having of three or more hole transportation layers. Moreover, it is desirable for the organic EL device of the present invention for an electron-accepting material to be included in at least one interface separating the hole transportation layers, each of which is constituted from different compounds, in a suitable manner illustrated in the organic EL device structures (A) to (F), in order to moderate a formation of the hole transport barrier between the hole transportation layers.

Furthermore, a problem may arise in the organic EL device structures (A) to (F) so that, if no ohmic contact is ensured between the anode electrode layer and the first hole transportation layer, especially when the anode electrode is not formed from ITO, but formed from a metal electrode material, a hole injection barrier may be formed in an interface between the anode electrode layer and the first hole transportation layer, thereby causing an increase of the driving voltage and an destabilization of the device operation. In such a case, it is contemplated to use a mixed layer disclosed by the inventors of this application in Japanese Unexamined Patent Publication (Kokai) Nos. 10-49771 and 2001-244079 and Japanese Patent Application No. 2003-358402. Namely, according to the methods disclosed in these patent documents, an electron-donating compound such as arylamine compounds which are widely used as an organic hole-transporting compound, and an electron-accepting material capable of forming an a charge transfer complex upon the oxidation-reduction reaction can be included as a mixture in a section of the hole injection layer adjacent to the anode electrode layer.

Specifically, the organic EL device structure (A) illustrated in Figure 1B may be modified to the corresponding organic EL device structure: Substrate/Anode Electrode Layer/Mixed Layer of Electron-donating Material and Electron-accepting Material/First Hole Transportation Layer/Electron-accepting Material Layer/Second Hole transportation Layer/Organic Structure Including Luminous layer/Cathode Electrode Layer. In particular, when a metal having a low work function (lower than 5.0eV) is used in the formation of the anode electrode layer, it is desirable for the mixed layer of the type described above is additionally applied as a layer adjacent to the anode electrode layer.

Furthermore, the inventors of the present invention have suggested a novel organic EL device structure which is different from conventional organic EL devices, in Japanese Unexamined Patent Publication (Kokai) No. 2003-272860. This novel organic EL device is characterized by having two or more light emissive units (corresponding to a layer portion sandwiched between the cathode electrode layer and the anode electrode layer in the conventional organic EL devices) partitioned by a "charge generation layer", and the charge generation layer can act as a hole-and electron-generating layer during application of voltage, and as a result, the light emissive units can simultaneously emit light as if multiple and corresponding conventional organic EL devices are connected in series. Note in this novel organic EL device, it desirable for the charge generation layer to have a resistivity of not less than 1.0×10² Ωcm.

In this novel organic EL device described above, each of the light emissive units has a hole transportation layer portion which is substantially the same as that of conventional organic EL devices, and thus the hole transportation layer and the structure thereof of the present invention can be applied to this novel organic EL device.

Moreover, whether or not a group of compounds and electron-accepting materials which may be an inorganic material or an organic material, both used in the construction of the hole transportation layer portion of the present invention, can form a charge transfer complex upon oxidation-reduction reaction between these compounds and materials can be confirmed by using the spectroscopic analytical method (measurement of the absorption spectrum). Specifically, compounds and electron-accepting materials, both constituting the hole transportation layer portion, when used alone, each cannot exhibit a peak of the absorption spectrum in a near IR region of the wavelength of 800 to 2,000 nm, however a mixed layer of these compounds and materials can exhibit a peak of the absorption spectrum in a near IR region of the wavelength of 800 to 2,000 nm, so that charge transfer was made between the compounds and the electron-accepting materials, both constituting the hole transportation layer portion, provides evidence for confirming whether or not the group of compounds and electron-accepting materials can form a charge transfer complex upon oxidation-reduction reaction between these compounds and materials.

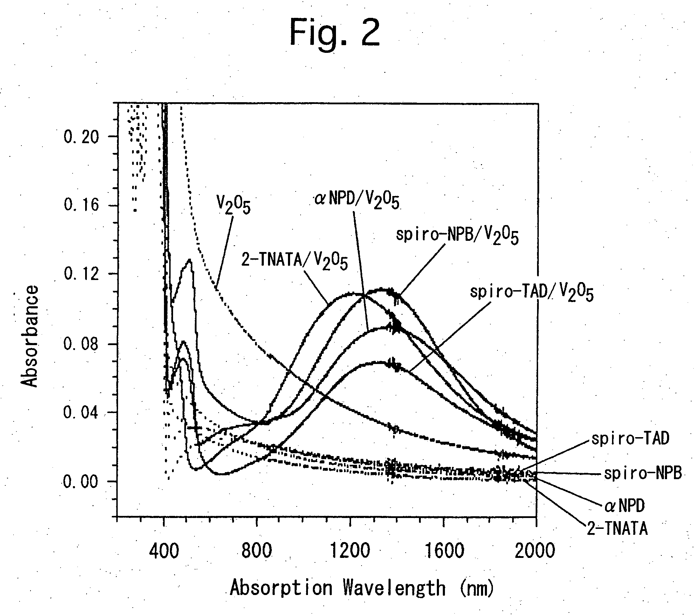

Figure 2 is a plotted graph of the absorption spectrum obtained when 2-TNATA, which is an arylamine compound (electron-donating compound), is represented by the following general formula: 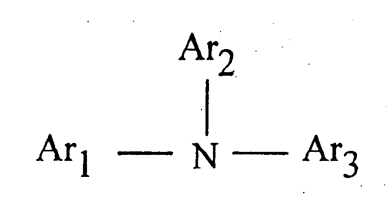 wherein Ar₁, Ar₂ and Ar₃ each represents an aromatic hydrocarbon group which may be substituted with any substituent group independently, αNPD (NPB), spiro-TAD, spiro-NPB or V₂O₅ (vanadium pentoxide; electron-accepting material) was used alone, along with the absorption spectrum obtained with the mixed layer of each of the arylamine compounds described above, and vanadium pentoxide.

In Figure 2, 2-TNATA, αNPD, spiro-TAD and spiro-NPB each is represented by the following formula:

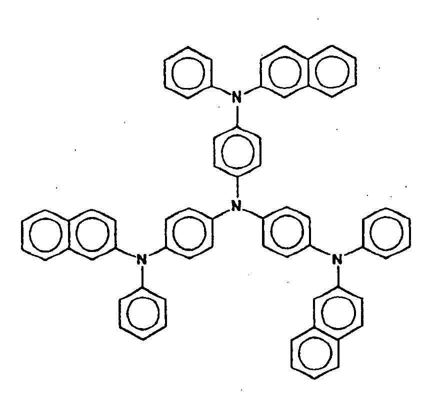

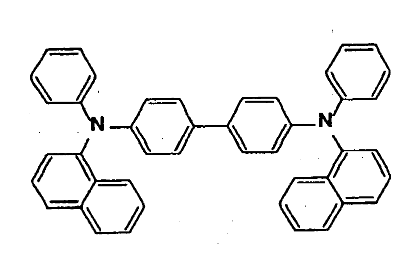

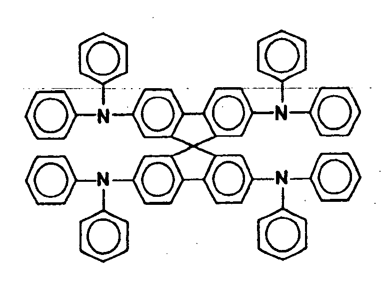

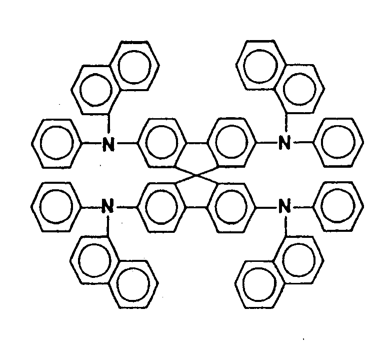

As can be appreciated from Figure 2, the arylamine compound and vanadium pentoxide, when used alone, each cannot exhibit a peak of the absorption spectrum in a near IR region of the wavelength of 800 to 2,000 nm, but the mixed layer of the arylamine compound and vanadium pentoxide can exhibit a notable peak of the absorption spectrum in a near IR region of the wavelength of 800 to 2,000 nm. Namely, the formation of a charge transfer complex can be confirmed in Figure 2.

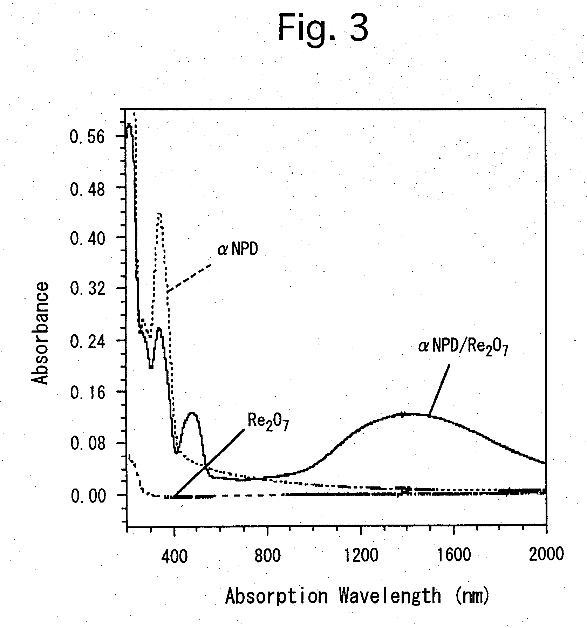

Furthermore, as can be appreciated from Figure 3, α-NPD, which is an arylamine compound, and dirhenium heptaoxide, when used alone, each cannot exhibit a peak of the absorption spectrum in a near IR region of the wavelength of 800 to 2,000 nm, but the mixed layer of α-NPD and dirhenium heptaoxide can exhibit a notable peak of the absorption spectrum in a near IR region of the wavelength of 800 to 2,000 nm. Namely, the formation of a charge transfer complex can be confirmed in Figure 3.

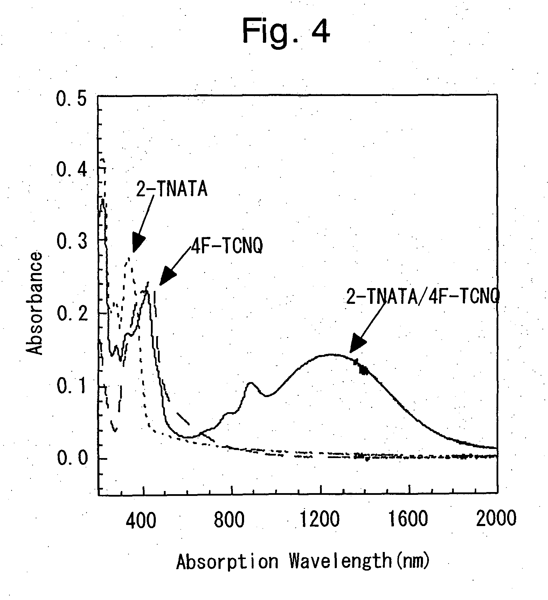

Figure 4 is a graph of the absorption spectrum obtained when 2-TNATA or tetrafluoro-tetracyanoquinodimethane (4F-TCNQ) represented by the following formula: 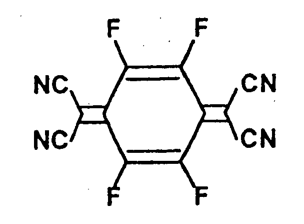 is used as a single layer, along with the absorption spectrum obtained with the mixed layer of 2-TNATA and 4F-TCNQ. In the graph of Figure 4, the absorbance is plotted along the ordinate and the absorption wavelength (nm) is plotted along the abscissas.

As observed in the graphs of Figures 2 through 4, the mixed layers each have an absorption spectrum which is not a product of the simple accumulation of the spectrum of each of the compounds or materials constituting the mixed layer, and has a third and new absorption peak, observed in a near IR region of 800 to 2,000 nm, which is generated upon the reaction accompanying the electron transfer (namely, oxidation-reduction reaction). The inventors of the present invention have studied and found that since radical cations are from the organic hole-transporting compound through oxidation-reduction reaction, it can be made easy to transfer hole between the hole transportation layers each including different compounds, and as a result, a driving voltage of the organic EL device can be lowered.

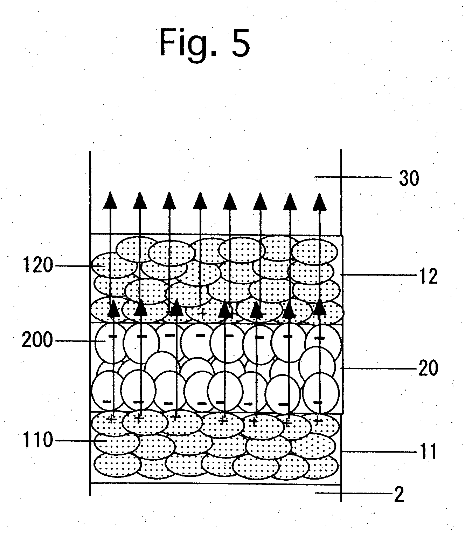

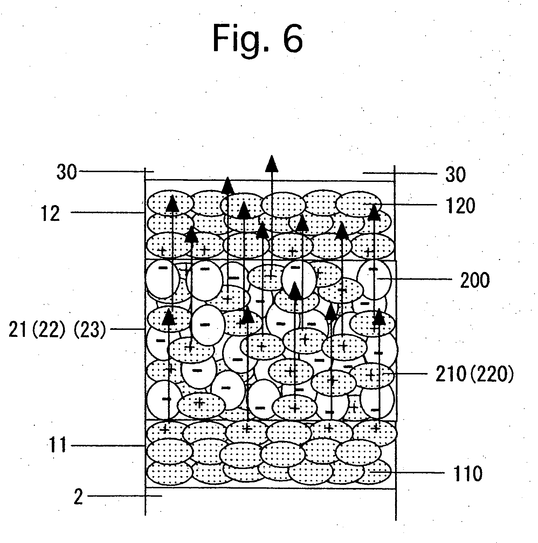

Moreover, it is easily supposed that when the hole-transporting material and the electron-accepting material are laminated in layers and contact each other, the oxidation-reduction reaction is generated in an interfacial portion where these materials contact each other. In practice, desired and intended characteristics can be obtained in the organic EL device of the present invention by forming the hole transportation layer section as a laminated structure. The generation of the oxidation-reduction reaction in the laminated structure is schematically illustrated in Figures 5 and 6.

Referring to Figures 5 and 6, the first hole transportation layer 11 and the second hole transportation layer 12 have first hole-transporting molecules 110 and second hole-transporting molecules 120, respectively. Furthermore, in the laminated organic EL device illustrated in Figure 5, the electron-accepting material layer 20 contains an electron-accepting material 200. On the other hand, in the mixed layer organic EL device illustrated in Figure 6, there is a layer 21 or 22 consisting of an electron-accepting material 200 and first hole-transporting molecules 210 or second hole-transporting molecules 220, or a layer 23 consisting of an electron-accepting material 200, first hole-transporting molecules 210 and second hole-transporting molecules 220.

### EXAMPLES

The present invention will be further described with reference to the following examples thereof. Note, however, that the present invention should not be restricted to these examples.

In the following examples, the formation of a layer from organic compounds, metal oxides, metals and others was carried out by using a vapor deposition apparatus of Anelva Co. The deposition rate of the vapor deposition material and the thickness of the deposited layers were controlled by using a layer formation monitor with a quartz oscillator, "CRTM-8000" of ULVAC, attached to the vapor deposition apparatus. The stylus step meter, "P10" of Tencor Co., was used to determine an actual layer thickness after the layer formation. The source meter "2400", of KEITHLEY, and the luminance meter "BM-8", of TOPCON, were used to evaluate the characteristics of the organic EL device. A DC voltage was applied stepwise at an increasing rate of 0.2 volts per 2 seconds to the organic EL device to determine the luminance and the electric current after lapse of one second from the completion of each increase of the voltage. The spectrum of the organic EL device was determined by using the optical multi-channel analyzer "PMA-11", of HAMAMATSU PHOTONICS, driven at a constant electric current.

### Reference Example 1

### Production of Conventional Organic EL Device Using CuPc

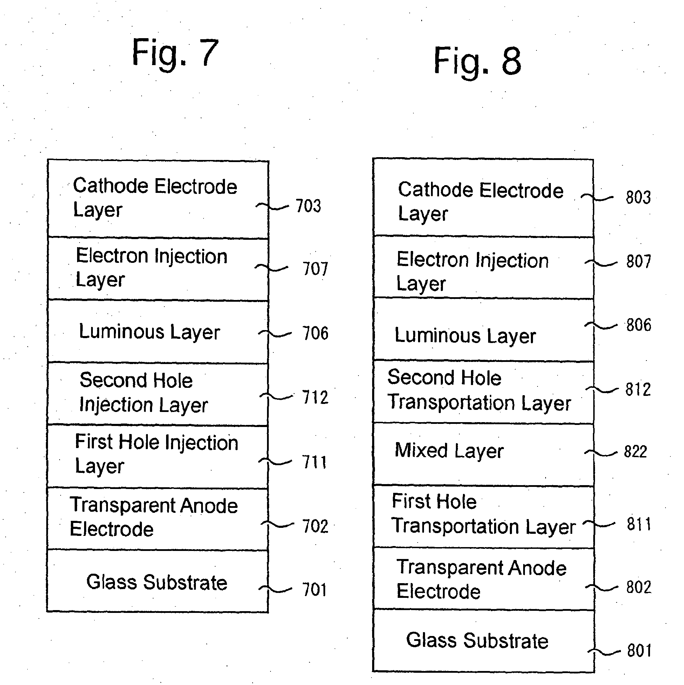

The organic EL device having a lamination structure illustrated in Figure 7 was produced as Reference Example 1.

The glass substrate 701 used in this example includes, as a transparent anode electrode (anode electrode layer) 702, a coating of ITO (indium-tin oxide; Nippon Sheet Glass Co., Ltd.) having a sheet resistance of about 10 Ω/□ (10 Ω /sq). Onto the ITO-coated glass substrate 701 was deposited CuPc represented by the following formula: 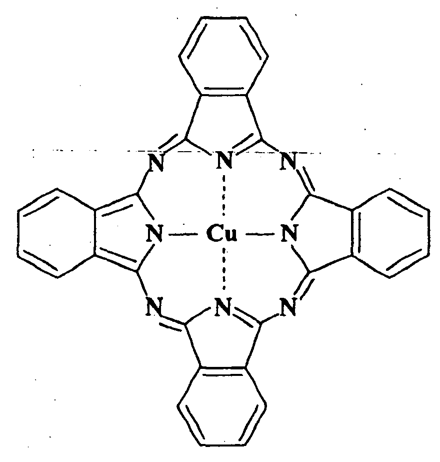 under vacuum of about 10⁻⁶ Torr and at the deposition rate of about 2Å/sec to form a first hole transportation layer (hole injection layer) 711 having a thickness of about 150Å.

Thereafter, onto the first hole transportation layer (hole injection layer) 711 was deposited Alpha( α )-NPD having a hole transporting property under vacuum of about 10⁻⁶ Torr and at a deposition rate of about 2Å/sec to form a second hole transportation layer 712 having a thickness of about 500 Å. Subsequently, onto the second hole transportation layer 712 was vapor deposited an aluminum complex of tris (8-quinolinolato) (hereinafter, referred to as "Alq") represented by the following formula: 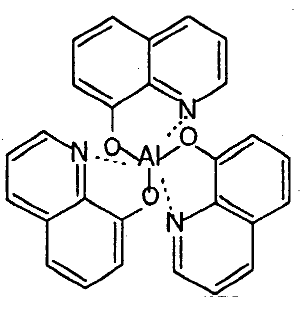 under the same vacuum vapor deposition conditions as those applied to the formation of the second hole transportation layer to form a luminous layer 706 having a thickness of about 700Å.

Subsequently, to form on the luminous layer 706 an electron injection layer 707 which was disclosed by the inventors of the present invention in Japanese Unexamined Patent Publication (Kokai) No. 11-233262, (8-quinolinato) lithium complex (hereinafter, referred to as "Liq") represented by the following formula: 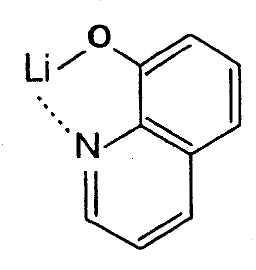 was deposited at a thickness of about 10Å.

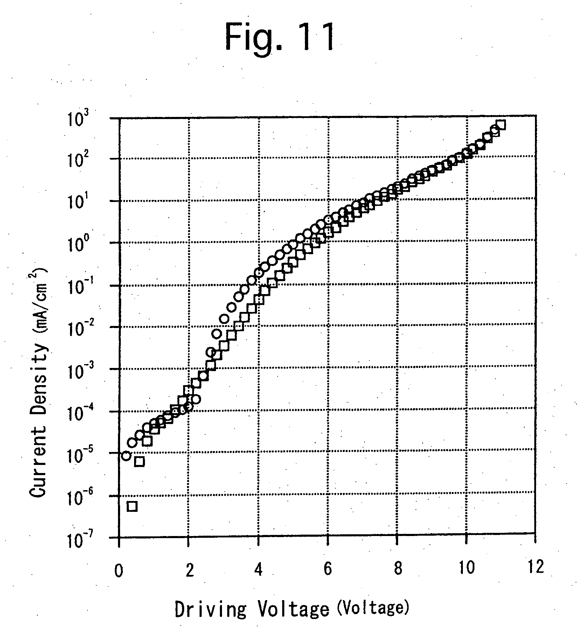

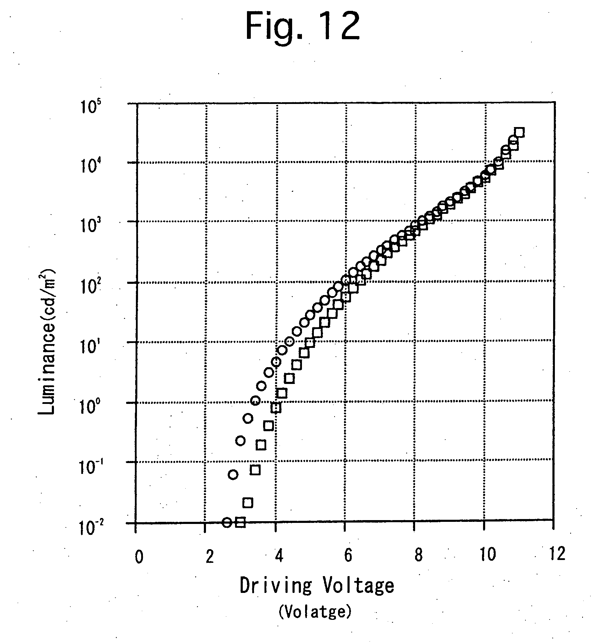

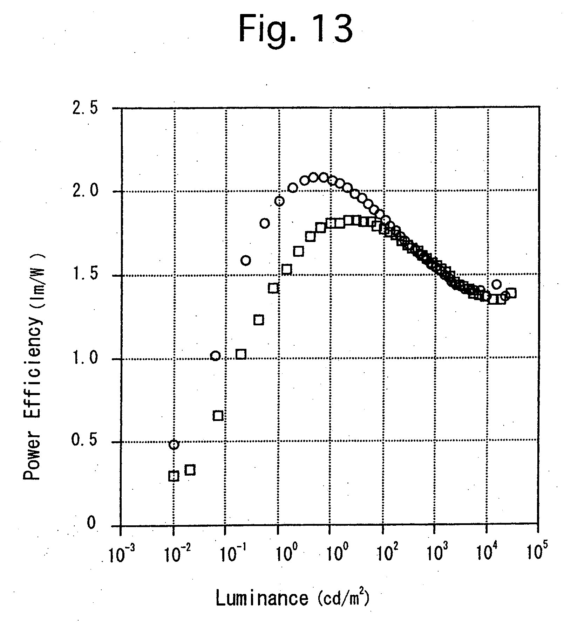

Following the formation of the electron injection layer 707, aluminum (Al) was deposited at the deposition rate of about 10Å/sec to form a cathode electrode layer 703 having a thickness of about 1,000Å. An organic EL device having a square light-emissive area of 0.2 cm (length) by 0.2 cm (width) is thus obtained. In the resulting organic EL device, a DC voltage was applied to between ITO (transparent anode electrode (anode electrode layer) 702) and Al (cathode electrode layer 703), and the luminance of the green light emitted from the luminous layer (Alq) 706 was measured. The results were plotted with white square symbols (□) in Figures 11 through 13, in which Figure 11 represents a graph of current density (mA/cm²) - voltage (V) characteristic curve of the organic EL device, Figure 12 represents a graph of luminance (cd/m²) - voltage (V) characteristic curve of the organic EL device, and Figure 13 represents a graph of power efficiency (lm/W) - and luminance (cd/m²) characteristic curve of the organic EL device. The turn on voltage of the organic EL device, i.e., the voltage at which the luminance of not less than 0.01 cd/m² is measured on the luminance meter, was 3.0 volts.

### Example 1

### Production of Organic EL Device According to Present Invention

The organic EL device having a lamination structure illustrated in Figure 8 was produced as Example 1.

A glass substrate 801 used in this example includes, as a transparent anode electrode (anode electrode layer) 802, a coating of ITO (indium-tin oxide; Nippon Sheet Glass Co., Ltd.) having a sheet resistance of about 10 Ω/□ . Onto the ITO-coated glass substrate 801 was deposited CuPc under conditions similar to those applied in Reference Example 1 to form a first hole transportation layer 811 having a thickness of about 150 Å. Subsequently, an electron-accepting material, V₂O₅ (vanadium pentoxide), which is one constitutional element of the present invention, and α-NPD, which is a constitutional material of the second hole transportation layer 802, were co-deposited at a molar ratio (V₂O₅ : α-NPD) of about 4:1 on the first hole transportation layer 811 to form a mixed layer 822 having a thickness of about 100Å. After formation of the mixed layer 822, in accordance with the procedure described in Reference Example 1, α -NPD as a second hole transportation layer 812, Alq as a luminous layer 806, Liq as an electron injection layer 807 and Al as a cathode electrode layer 803 were deposited in sequence to form an organic EL device.

In the resulting organic EL device, a DC voltage was applied to between ITO (transparent anode electrode 802) and Al (cathode electrode layer 803), and the luminance of the green light emitted from the luminous layer (Alq) 806 was measured. The results were plotted with white circle symbols (○) in Figures 11 through 13, in which Figure 11 represents a graph of current density (mA/cm²) - voltage (V) characteristic curve of the organic EL device, Figure 12 represents a graph of luminance (cd/m²) - voltage (V) characteristic curve of the organic EL device, and Figure 13 represents a graph of power efficiency (lm/W) - and luminance (cd/m²) characteristic curve of the organic EL device. The turn on voltage of the organic EL device was 2.6 volts.

### Reference Example 2

### Production of Conventional Organic EL Device Using 2-TNATA

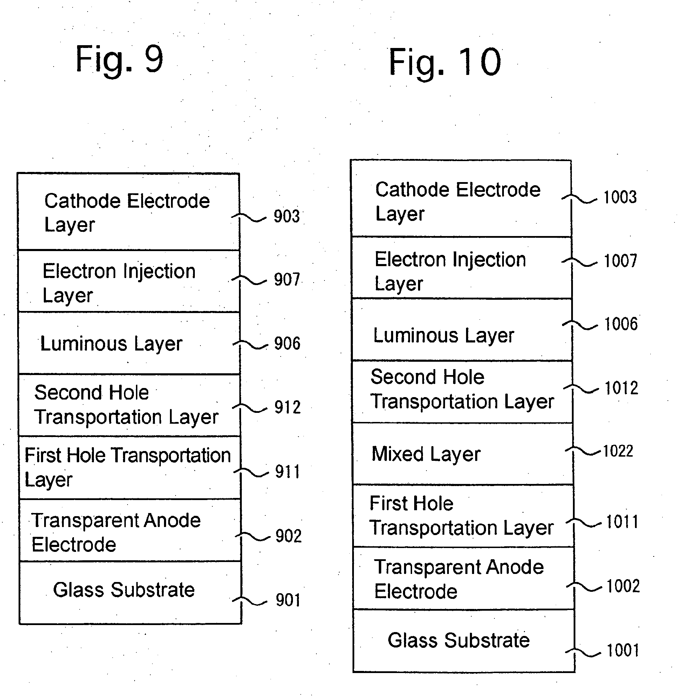

The organic EL device having a lamination structure illustrated in Figure 9 was produced as Reference Example 2. The structure of the organic EL device is similar to that of Reference Example 1 except that the CuPc layer (150Å) used as the first hole transportation layer in Reference Example 1 was replaced with a 2-TNATA layer (600 Å ), described above.

Namely, a transparent anode electrode (ITO) 902, a first hole transportation layer (2-TNATA) 911, a second hole transportation layer (α-NPD) 912, a luminous layer (Alq) 906, an electron injection layer (Liq) 907 and a cathode electrode layer (903) were deposited, in sequence, on the glass substrate 901 in accordance with the manner described in Reference Example 1 to form an organic EL device.

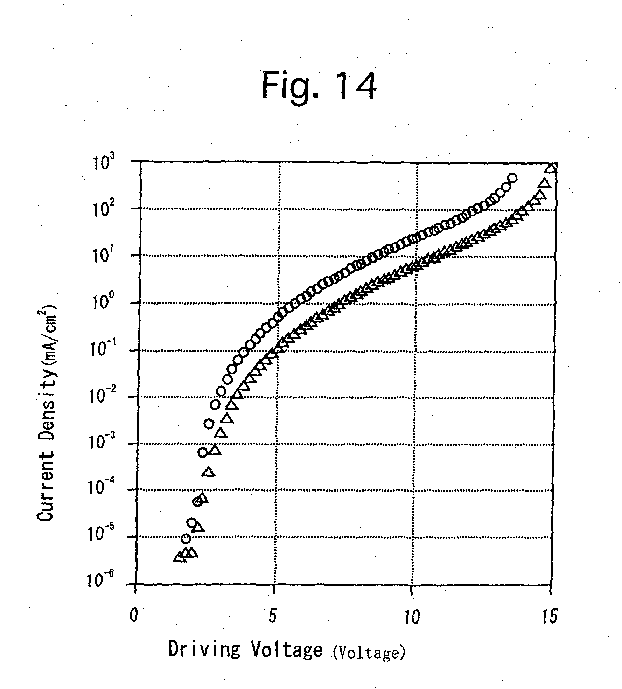

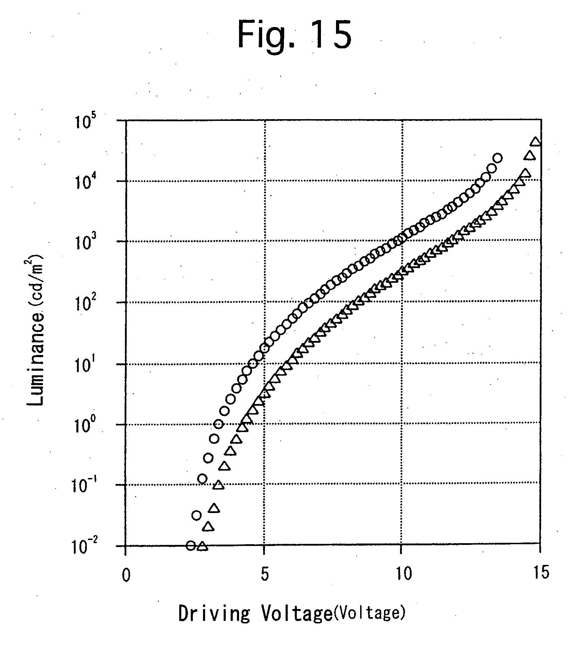

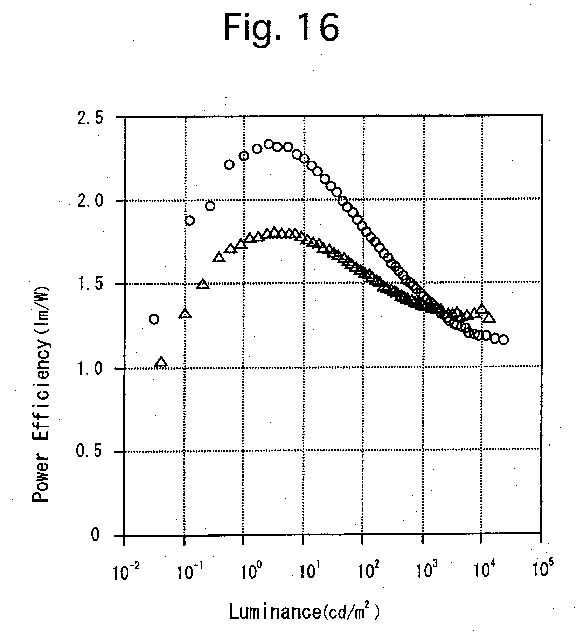

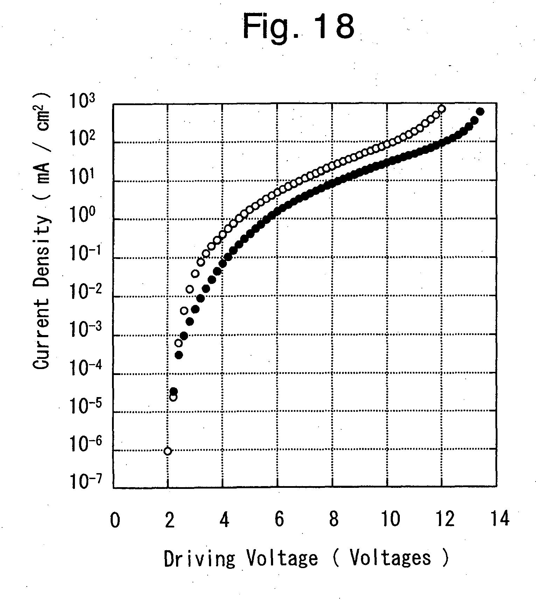

In the resulting organic EL device, a DC voltage was applied between ITO (transparent anode electrode 902) and Al (cathode electrode layer 903), and the luminance of the green light emitted from the luminous layer (Alq) 906 was measured. The results were plotted with white triangle symbols (Δ) in Figures 14 through 16 and with black circle symbols (●) in Figures 18 through 20 and Figures 27 through 29, in which Figures 14, 18 and 27 each represents a graph of current density (mA/cm²) - voltage (V) characteristic curve of the organic EL device, Figures 15, 19 and 28 each represents a graph of luminance (cd/m²) - voltage (V) characteristic curve of the organic EL device, and Figures 16, 20 and 29 each represents a graph of power efficiency (1m/W) - and luminance (cd/m²) characteristic curve of the organic EL device. The turn on voltage of the organic EL device was 2.8 volts.

### Example 2

### Production of Organic EL Device According to Present Invention

An organic EL device having the lamination structure illustrated in Figure 10 was produced as Example 2. The structure of the organic EL device was similar to that of Reference Example 2 except that a mixed layer 1022 having a thickness of about 100 Å was inserted between the first hole transportation layer (2-TNATA) and the second hole transportation layer (α-NPD) in the organic EL device of Reference Example 2 by co-depositing an electron-accepting material, V₂O₅ (vanadium pentoxide), which is one constitutional element of the present invention, and α-NPD, which is a constitutional material of the second hole transportation layer 1012 at a molar ratio (V₂O₅: α-NPD) of about 4 : 1.

Namely, a transparent anode electrode (ITO) 1002, a first hole transportation layer (2-TNATA) 1011, a mixed layer 1022 formed upon co-deposition of an electron-accepting material, V₂O₅ (vanadium pentoxide) and α -NPD, which is a constitutional material of the second hole transportation layer 1012 at a molar ratio (V₂O₅: α-NPD) of about 4 : 1, a second hole transportation layer (α-NPD) 1012, a luminous layer (Alq) 1006, an electron injection layer (Liq) 1007, and a cathode electrode layer (1003) were deposited, in sequence, on the glass substrate 1001 in accordance with the manner described in Reference Example 2 to form an organic EL device.

In the resulting organic EL device, a DC voltage was applied between ITO (transparent anode electrode 1002) and Al (cathode electrode layer 1003), and the luminance of the green light emitted from the luminous layer (Alq) 1006 was measured. The results were plotted with white circle symbols (○) in Figures 14 through 16 in which Figure 14 represents a graph of current density (mA/cm²) - voltage (V) characteristic curve of the organic EL device, Figure 15 represents a graph of luminance (cd/m²) - voltage (V) characteristic curve of the organic EL device, and Figure 16 represents a graph of power efficiency (lm/W) - and luminance (cd/m²) characteristic curve of the organic EL device. The turn on voltage of the organic EL device was 2.4 volts.

### Example 3

### Production of Organic EL Device According to Present Invention

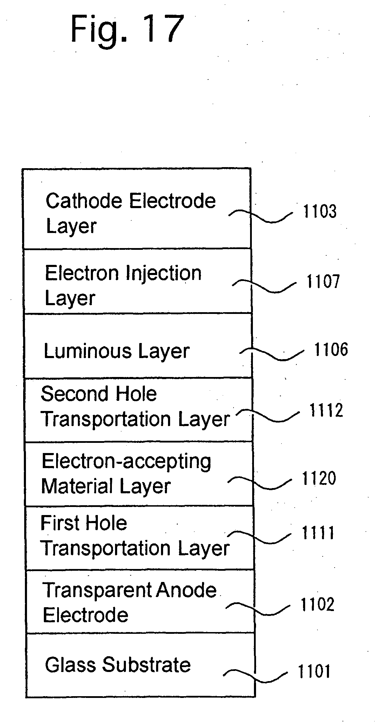

The organic EL device having the lamination structure illustrated in Figure 17 was produced as Example 3. The structure of the organic EL device was similar to that of Reference Example 2 except that an electron-accepting material layer (4F-TCNQ) 1120 having a thickness of about 10 Å, which is one constitutional element of the present invention, was deposited and inserted between the first hole transportation layer (2-TNATA) and the second hole transportation layer (α-NPD) in the device of Reference Example 2.

Namely, a transparent anode electrode (ITO) 1102, a first hole transportation layer (2-TNATA) 1111, an electron-accepting material layer (4F-TCNQ) 1120, a second hole transportation layer (α-NPD) 1112, a luminous layer (Alq) 1106, an electron injection layer (Liq) 1107, and a cathode electrode layer (1103) were deposited, in sequence, on the glass substrate 1101 in accordance with the manner described in Reference Example 2 to form an organic EL device.

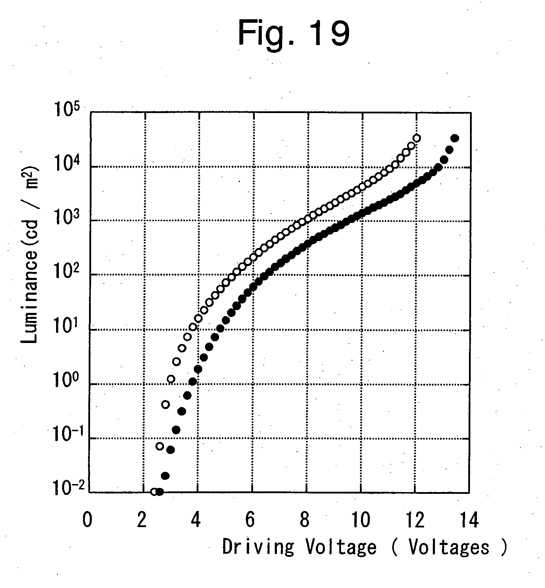

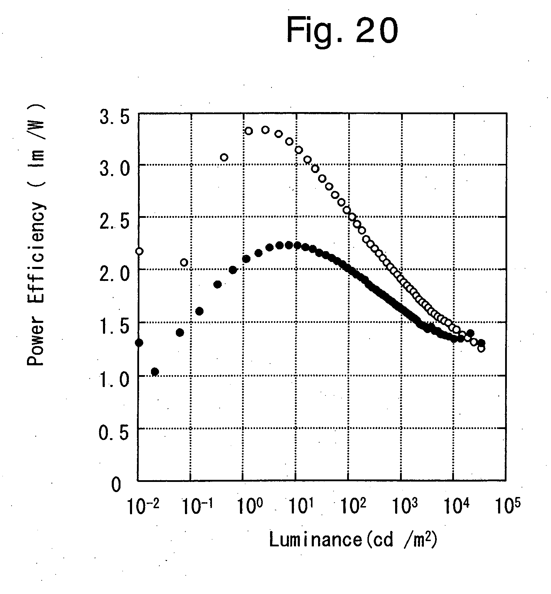

In the resulting organic EL device, a DC voltage was applied to between ITO (transparent anode electrode 1102) and Al (cathode electrode layer 1103), and the luminance of the green light emitted from the luminous layer (Alq) 1106 was measured. The results were plotted with white circle symbols (○) in Figures 18 through 20 in which Figure 18 represents a graph of current density (mA/cm²) - voltage (V) characteristic curve of the organic EL device, Figure 19 represents a graph of luminance (cd/m²) - voltage (V) characteristic curve of the organic EL device, and Figure 20 represents a graph of power efficiency (lm/W) - and luminance (cd/m²) characteristic curve of the organic EL device. The turn on voltage of the organic EL device was 2.4 volts.

### Example 4

### Production of Organic EL Device According to Present Invention

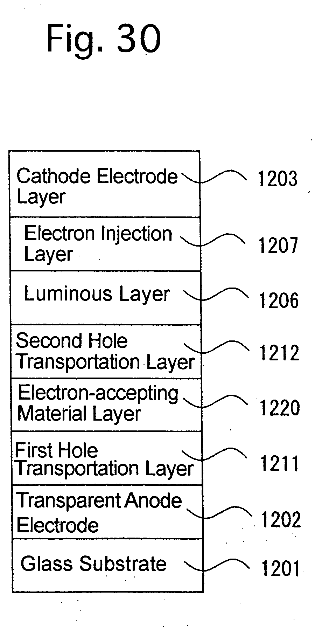

The organic EL device having the lamination structure illustrated in Figure 30 was produced as Example 4. The structure of the organic EL device was similar to that of Reference Example 2 except that an electron-accepting material layer (PNB) 1220 having a thickness of about 40Å, which is one constitutional element of the present invention, was deposited and inserted between the first hole transportation layer (2-TNATA) and the second hole transportation layer (α-NPD) in the device of Reference Example 2. The PNB used herein is represented by the following formula:

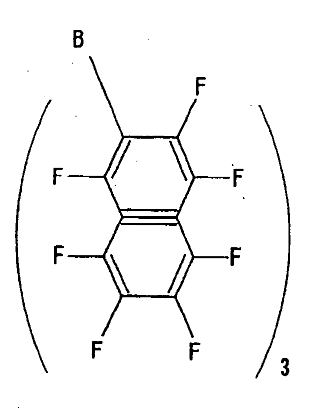

Namely, a transparent anode electrode (ITO) 1202, a first hole transportation layer (2-TNATA) 1211, an electron-accepting material layer (PNB) 1220, a second hole transportation layer (α-NPD) 1212, a luminous layer (Alq) 1206, an electron injection layer (Liq) 1207 and a cathode electrode layer (1203) were deposited, in sequence, on the glass substrate 1201 in accordance with the manner described in Reference Example 2 to form an organic EL device.

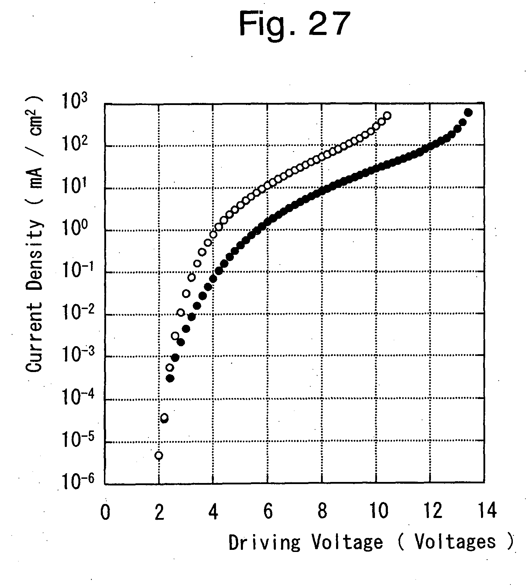

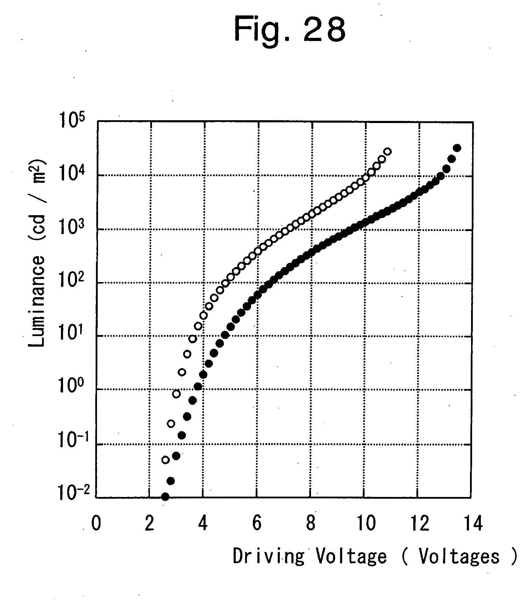

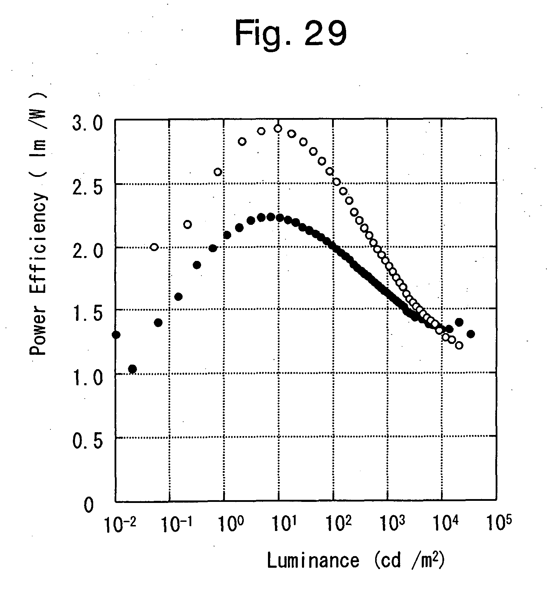

In the resulting organic EL device, a DC voltage was applied between ITO (transparent anode electrode 1202) and Al (cathode electrode layer 1203), and the luminance of the green light emitted from the luminous layer (Alq) 1206 was measured. The results were plotted with white circle symbols (○) in Figures 27 through 29 in which Figure 27 represents a graph of current density (mA/cm²) - voltage (V) characteristic curve of the organic EL device, Figure 28 represents a graph of luminance (cd/m²) - voltage (V) characteristic curve of the organic EL device, and Figure 29 represents a graph of power efficiency (lm/W) - and luminance (cd/m²) characteristic curve of the organic EL device. The turn on voltage of the organic EL device was 2.4 volts.

As can be appreciated from the above results, according to the organic EL device of the present invention in which an electron-accepting material does not contact an anode electrode and is contained in an interfacial site between two or more hole transportation layers of different materials, it becomes possible to lower a device driving voltage including a turn on voltage, thereby improving an efficiency of the power conversion as a result (as shown in Fig.13, 16, 20, and 29). In addition, since a hole injection layer material which is used in a position adjacent to the anode electrode layer and is known to be important for stabilized durability can be used in the organic EL device without omission or modification, it becomes possible to simultaneously satisfy a higher efficiency and an extended durability in the EL device.

### Test Example

In order to evaluate an interaction between the electron-accepting material and the hole-transporting material in the present invention, a method is provided based on the determination of a variation of the resistivity, defined as an inverse number of the conductivity, in the mixed layer of the electron-accepting material and the hole-transporting material, in addition to the spectrographic method described above. In this test example, a resistivity (Ω cm) was measured in accordance with two different methods depending on the values (range) of the resistivity of the materials to be tested (hereinafter, test materials).

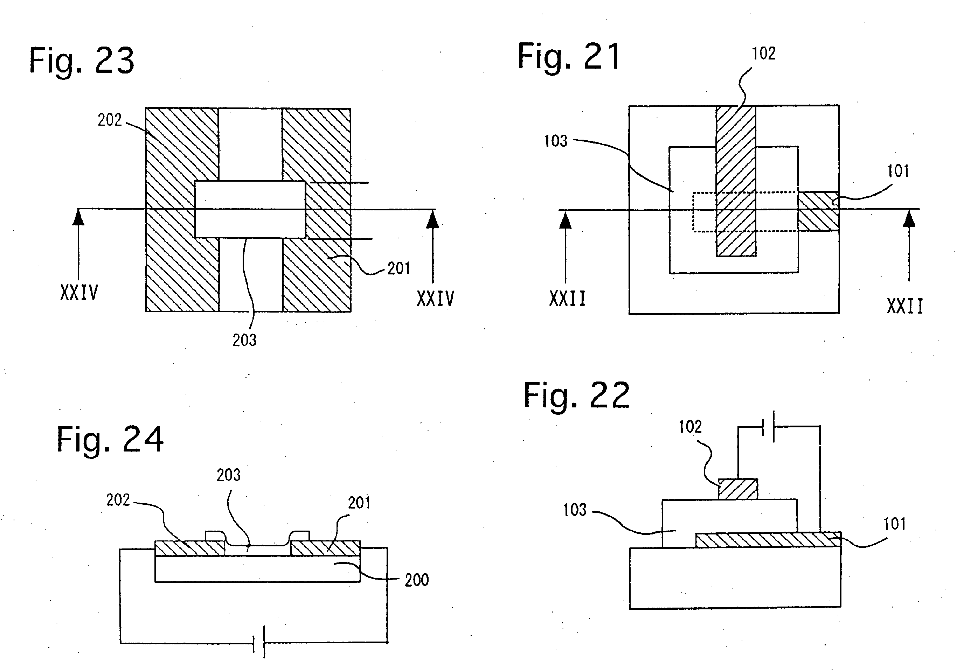

The first measuring method (sandwich method) is a method suitable for materials having a relatively large resistivity, and the measurement is carried out by sandwiching a vapor deposition layer of the test material with electrodes (see, the resistivity evaluation device having a sandwich structure shown in Figures 21 and 22). The resistivity of the test materials is calculated from a ratio of the electric field E (V/cm), obtained from an applied voltage (V) and a layer thickness (cm) of the deposition layer of the test material, i.e., distance between the electrodes, and a current density (A/cm²), obtained from a measured current value (A) and a cross-sectional area (cm²) of the current flowing region.

Specifically, the resistivity evaluation device used in this test example was produced by depositing a test material 103 at a desired thickness on an ITO electrode 101 (if necessary, on an aluminum electrode having a width of about 2 mm), followed by finally depositing an aluminum electrode 102 (having a width of about 2 mm as in the above aluminum electrode) in such a manner that the aluminum electrode 102 is crossed with the ITO electrode 101.

The second measuring method (co-planar method) is suitable for materials having a relatively small resistivity, and the measurement is carried out by using a resistivity evaluation device having a co-planar structure. Namely, as shown in Figures 23 and 24, a substrate 200 having previously deposited as layers on the same plane surface thereof electrodes which are used as an anode electrode layer 201 and a cathode electrode layer 202 are prepared. The anode electrode layer 201 and the cathode electrode layer 202 are disposed at a predetermined distance L (cm). Subsequently, a test material is deposited, through a metal mask of defining a deposition area and having an opening with the predetermined opening width W (cm), on the substrate 200 to form a deposited layer 203 of the test material having a predetermined thickness t (cm). In this method, an electric field E(V/cm) of the test material is calculated by dividing an applied voltage (V) by a distance L (cm) between the electrodes, and a current density (A/cm²) is calculated by dividing a measured current value (A) by a cross-sectional area of the current flowing region (in this example, W x t (cm²)). The resistivity (Ω cm) is calculated from the resulting calculation results as in the sandwich method described above.

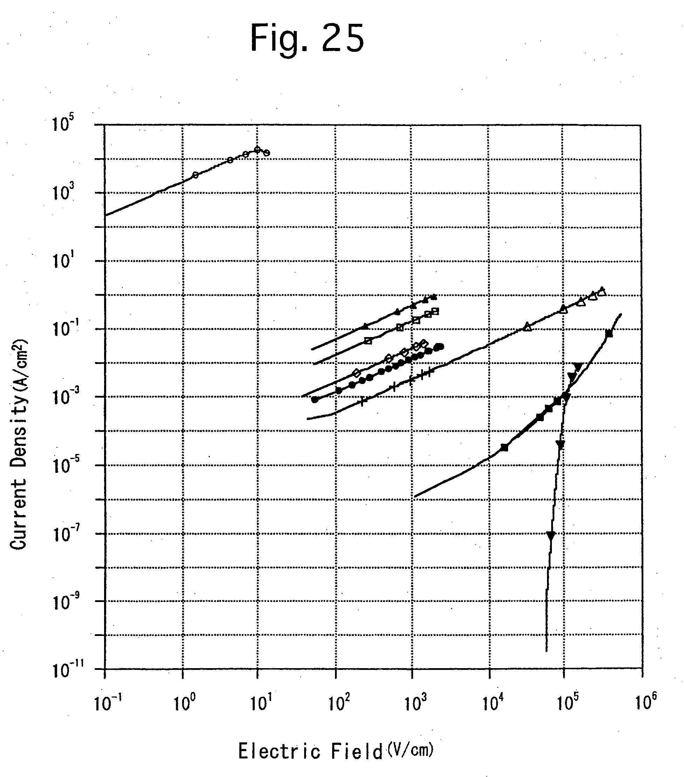

The results of the determination of the resistivity are plotted in Figure 25. The test materials used herein are ITO (transparent electrode material), V₂O₅, a co-deposition layer of V₂O₅ and αNPD (V₂O₅ : αNPD = 4:1; 1:1 and 1:2) (three different molar ratios); a co-deposition layer of V₂O₅ and 2-TNATA (V₂O₅ : 2-TNATA = 4:1) (molar ratio); and αNPD. The resistivity of each of ITO, the co-deposition layer of V₂O₅ and αNPD, and the co-deposition layer of V₂O₅ and 2-TNATA was measured using a resistivity evaluation device having a co-planar structure, and the resistivity of αNPD was measured using a resistivity evaluation device having a sandwich structure. Furthermore, with regard to αNPD, to make charge injection from the electrode under the ohmic conditions, the measurement of the resistivity was carried out after formation of a co-deposition layer of V₂O₅ and α NPD, i.e., the layer having a composition of the hole injection layer disclosed in Japanese Patent Application No. 2003-358402, at a relatively thin thickness of 50Å in a portion adjacent to each of the electrodes, followed by sandwiching a 1,000Å-thick α NPD layer with the electrodes. Furthermore, the resistivity of V₂O₅ was measured using both of the co-planar method and the sandwich method to confirm that substantially the same resistivities can be obtained regardless of the measuring method used.

The resistivities calculated from the results plotted in Figure 25 are as follows.
(1) Results obtained using the co-planar method:
   - ○:: ITO
   4.6 x 10⁻⁴ Ωcm;
   - ●:: V₂O₅
   7.2 x 10⁴ Ωcm;
   - ▲:: co-deposition layer of V₂O₅ and αNPD = 4:1
   2.0 x 10³ Ωcm;
   - ◇:: co-deposition layer of V₂O₅ and αNPD = 1:1
   3.6 x 10⁴ Ωcm;
   - +:: co-deposition layer of V₂O₅ and αNPD = 1: 2
   2.9 x 10⁵ Ωcm; and
   - □:: co-deposition layer of V₂O₅ and 2-TNATA = 4:1
   5.8 x 10³ Ωcm.
(2) Results obtained using the sandwich method:
   - Δ:: ITO/V₂O₅ /Al
   2.8 x 10⁵ Ωcm;
   - ▼:: ITO/ α NPD/Al
   1. 5 x 10¹³ Ωcm; and
   - ■:: ITO/V₂O₅: αNPD(50Å)/αNPD(1,000Å)/V₂O₅ : αNPD(50Å)Al
   8.0 x 10⁸ Ωcm.

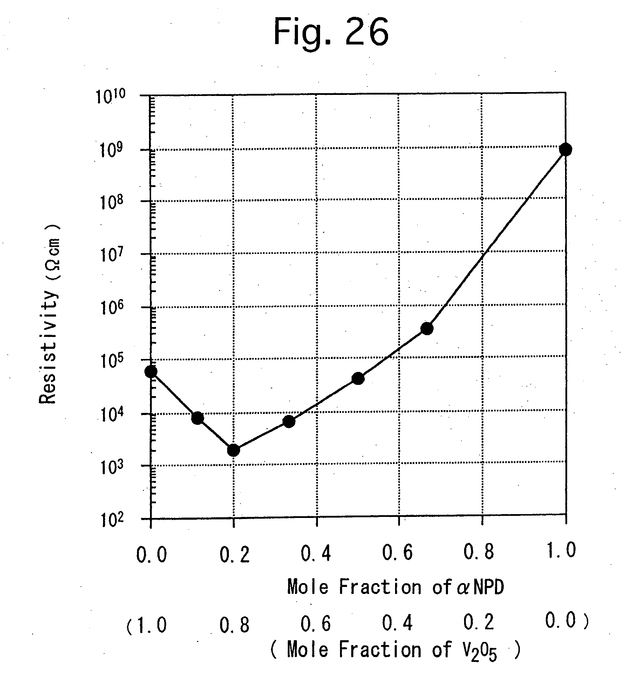

Furthermore, a relationship between the mole fraction of V₂O₅ (or α NPD) in the co-deposition layer and the resulting resistivity is plotted in the graph of Figure 26. As shown in the graph, a mixed layer of these materials can exhibit a low resistivity as a result of mixing of the materials, while such a low resistivity could not be obtained with sole use of each material. This result indicates that an oxidation-reduction reaction could be induced as a result of the electron transfer (between the hole-transporting materials and the electron-accepting materials). Furthermore, it basically proves that the contact and interaction between the electron-accepting material such as V₂O₅ and the hole-transporting material is effective in lowering the driving voltage and increasing the efficiency in the organic EL devices.

According to the present invention, two or more hole transportation layers are used in combination to transfer holes injected from the anode electrode layer to a luminous layer to diminish a hole transport barrier, while maintaining a driving durability stability in an organic EL device, thereby lowering the device driving voltage including a turn-on voltage, and thus reducing power consumption.

Obvious changes may be made in the specific embodiments of the present invention described herein, such modifications being within the spirit and scope of the invention claimed. It is indicated that all matter contained herein is illustrative and does not limit the scope of the present invention.

## Claims

1. An organic electroluminescent device comprising:
an anode electrode layer;
a cathode electrode layer opposed to the anode electrode layer; and
a luminous layer containing an organic compound disposed between said anode electrode layer and said cathode electrode layer,
wherein an excitation state of the organic compound in said luminous layer is created upon a hole injection from said anode electrode layer, and an electron injection from said cathode electrode layer, thereby causing light emission in said organic electroluminescent device,
wherein an electron-accepting material is provided in at least one hole transportation layer capable of transporting holes injected from said anode electrode layer disposed between said anode electrode layer and said cathode electrode layer, and said electron-accepting material is positioned at a site which is not adjacent to said anode electrode layer.

2. The organic electroluminescent device according to claim 1, wherein said hole transportation layer includes at least two hole transportation layers which independently include different materials, and wherein an electron-accepting material is included in an interface separating said hole transportation layers.

3. The organic electroluminescent device according to claim 2, wherein said electron-accepting material is in a form of a layer sandwiched between said hole transportation layers.

4. The organic electroluminescent device according to claim 2, wherein said electron-accepting material is mixed in at least one of said hole transportation layers adjacent to each other.

5. The organic electroluminescent device according to claim 4, wherein said hole transportation layer includes a hole-transporting material, and said electron-accepting material and said hole-transporting material constitutes a mixture layer formed upon co-deposition of said electron-accepting material and said hole-transporting material.

6. The organic electroluminescent device according to claim 1, wherein said electron-accepting material includes an inorganic material.

7. The organic electroluminescent device according to claim 1, wherein said electron-accepting material includes an organic material.

8. The organic electroluminescent device according to claim 6, wherein said inorganic material includes a metal oxide.

9. The organic electroluminescent device according to claim 6, wherein said inorganic material includes a metal halide.

10. The organic electroluminescent device according to claim 8, wherein said metal oxide includes one of vanadium pentoxide (V₂O₅), dirhenium heptaoxide (Re₂O₇), molybdenum trioxide (MoO₃), and tungsten trioxide (WO₃).

11. The organic electroluminescent device according to claim 7, wherein said organic material includes at least one fluorine atom as a substituent.

12. The organic electroluminescent device according to claim 11, wherein said organic material includes tetrafluoro-tetracyanoquinodimethane (F₄-TCNQ).

13. The organic electroluminescent device according to claim 11, wherein said organic material includes a boron atom and a fluorine atom.

14. The organic electroluminescent device according to claim 7, wherein said organic material includes at least one cyano group as a substituent.

15. The organic electroluminescent device according to claim 14, wherein said organic material includes tetrafluoro-tetracyanoquinodimethane (F₄-TCNQ).

16. The organic electroluminescent device according to claim 7, wherein said organic material includes a boron atom.

17. The organic electroluminescent device according to claim 16, wherein said organic material includes a boron atom and a fluorine atom.

18. The organic electroluminescent device according to claim 17, wherein said organic material includes tris-β-(pentafluoronaphthyl)borane (PNB).

19. The organic electroluminescent device according to claim 1, wherein said organic hole-transporting material contacting said organic electron-accepting material includes an arylamine compound represented by said following formula: 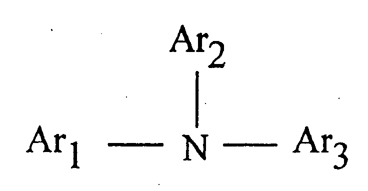 in which Ar₁, Ar₂ and Ar₃ each represents an aromatic hydrocarbon group which may have substituent independently.

20. The organic electroluminescent device according to claim 1, wherein said organic hole-transporting material contacting said organic electron-accepting material includes a pigment type organic compound.

21. The organic electroluminescent device according to claim 20, wherein said pigment type organic compound includes a porphyrin compound or a derivative thereof.

22. The organic electroluminescent device according to claim 20, wherein said pigment type organic compound includes a quinacridone compound or a derivative thereof.

23. The organic electroluminescent device according to claim 20, wherein said pigment type organic compound includes an indanthrene compound or a derivative thereof.

24. An organic electroluminescent device comprising:
an anode electrode layer and a cathode electrode layer which are disposed opposite to each other; and
at least two light emissive units each including at least one luminous layer disposed between said anode electrode layer and said cathode electrode layer, wherein
said light emissive units are partitioned with at least one charge generation layer,
said charge generation layer includes an electrical insulating layer having a resistivity of not less than 1.0 × 10² Ωcm,
said light emissive unit includes at least one hole transportation layer,
at least one of said light emissive units includes an electron-accepting material in said hole transportation layer, and
said electron-accepting material is positioned at a site which is not adjacent to said anode electrode layer and said charge generation layer.

25. The organic electroluminescent device according to claim 24, wherein said hole transportation layer includes at least two hole transportation layers which independently include different materials, and an electron-accepting material is included in an interface separating said hole transportation layers.

26. The organic electroluminescent device according to claim 25, wherein said electron-accepting material is in form of a layer sandwiched between said hole transportation layers.

27. The organic electroluminescent device according to claim 25, wherein said electron-accepting material is mixed in at least one of said hole transportation layers adjacent to each other.

28. The organic electroluminescent device according to claim 27, wherein said hole transportation layer includes a hole-transporting material,
wherein said electron-accepting material and said hole-transporting material constitute a mixture layer formed upon co-deposition of said electron-accepting material and said hole-transporting material.
